# EUROPÄISCHE PATENTANMELDUNG

(11) **EP 4 191 460 A1**
(43) Veröffentlichungstag der Anmeldung: **07.06.2023**
(21) Anmeldenummer: 21212539.7
(22) Anmeldetag: 06.12.2021
(51) Int. Cl.: G06F 30/12, G06F 30/20, G06Q 50/08

(54) **VERFAHREN ZUM ERSTELLEN EINES DREIDIMENSIONALEN BODENMODELLS ZU EINEM GRUNDSTÜCK**

(71) Anmelder: BAUER Spezialtiefbau GmbH, 86529 Schrobenhausen (DE)
(72) Erfinder: Kaiser, Holger, 18055 Rostock (DE); Haidacher, Dominic, 86529 Schrobenhausen (DE)
(74) Vertreter: Wunderlich & Heim Patentanwälte Partnerschaftsgesellschaft mbB

(57) **Zusammenfassung**

Die Erfindung betrifft ein Verfahren zum Erstellen eines dreidimensionalen Bodenmodells zu einem Grundstück, insbesondere einem Baugrundstück, wobei Daten zu einem Lageplan des Grundstücks erfasst werden, Daten zu mehreren Sondierungsbohrungen erfasst werden, welche auf dem Grundstück an bestimmten Sondierungsstellen durchgeführt wurden und zu jeder Sondierungsbohrung ein Schichtaufbau des Bodens mit einzelnen Schichten und ihrer Schichtdicke ermittelt wurden, die einzelnen Sondierungsstellen in dem erfassten Lageplan des Grundstücks eingetragen werden, wobei mittels einer Rechnereinheit die einzelnen Schichten zu jeder Sondierungsbohrung analysiert und jeweils einer gemeinsamen Bodenschicht zugeordnet werden, abhängig von der Lage der einzelnen Sondierungsbohrungen zueinander ein Schichtdickenverlauf der einzelnen Bodenschichten innerhalb des Grundstücks interpoliert wird und so durch Rechnereinheit das dreidimensionale Bodenmodell für das Grundstück erstellt wird.

## Beschreibung

Die Erfindung betrifft ein Verfahren zum Erstellen eines dreidimensionalen Bodenmodells zu einem Grundstück, insbesondere einem Baugrundstück, gemäß dem Anspruch 1.

Bei Bauvorhaben ist häufig ein Erstellen einer Baugrube mit Bodenaushub erforderlich. Ein Zeit- und Kostenaufwand für den Bodenaushub hängt dabei maßgeblich von der Art und dem Aufbau des Bodens an der Baustelle ab. Insbesondere bei größeren Bauvorhaben ist es üblich oder sogar erforderlich, vor Beginn der Baumaßnahmen ein Baugrundgutachten zu erstellen.

In einem derartigen Baugrundgutachten sind Angaben zum Aufbau des Bodens enthalten. Diese Angaben können auf bekannten Werten von Grundstücken aus dem Nahbereich des Baugrundstückes oder aufgrund von einer oder mehreren Sondierungsbohrungen beruhen.

Üblicherweise wird basierend auf dem Baugrundgutachten ein erforderlicher Aufwand zum Erstellen einer Baugrube abgeschätzt. Dieses Abschätzen erfolgt dabei anhand von Erfahrungswerten, welche von einem erfahrenen Fachmann und Planer bei der Berechnung des Aufwandes zugrunde gelegt werden.

Derartige Abschätzungen zum Arbeits- und Kostenaufwand sind auch bei Einsatz erfahrener Fachleute sehr zeitaufwendig und mit Restungenauigkeiten verbunden. Der Erfindung liegt die **Aufgabe** zugrunde, ein Verfahren anzugeben, mit welchen ein besonders effizientes und zuverlässiges Erstellen von Informationen zu einem Baugrundstück ermöglicht wird.

Die Aufgabe wird durch ein Verfahren mit den Merkmalen des Anspruchs 1 gelöst. Bevorzugte Ausführungsformen sind in den abhängigen Ansprüchen angegeben.

Die Erfindung betrifft ein Verfahren zum Erstellen eines dreidimensionalen Bodenmodells zu einem Grundstück, insbesondere einem Baugrundstück, wobei Daten zu einem Lageplan des Grundstücks erfasst werden, Daten zu mehreren Sondierungsbohrungen erfasst werden, welche auf dem Grundstück an bestimmten Sondierungsstellen durchgeführt wurden und zu jeder Sondierungsbohrung ein Schichtaufbau des Bodens mit einzelnen Schichten und ihrer Schichtdicke ermittelt wurden, die einzelnen Sondierungsstellen in dem erfassten Lageplan des Grundstücks eingetragen werden, wobei mittels einer Rechnereinheit die einzelnen Schichten zu jeder Sondierungsbohrung analysiert und jeweils einer gemeinsamen Bodenschicht zugeordnet werden, abhängig von der Lage der einzelnen Sondierungsbohrungen zueinander ein Schichtdickenverlauf der einzelnen Bodenschichten innerhalb des Grundstücks interpoliert wird und so durch die Rechnereinheit das dreidimensionale Bodenmodell für das Grundstück erstellt wird.

Das erfindungsgemäße Verfahren verwendet eine Rechnereinheit, welche ausgebildet ist, erfasste Daten zu einem Lageplan des Grundstücks und Daten zum näheren Sondierungsbohrungen mit erhaltenen Informationen zum Schichtaufbau des Bodens aufzunehmen und zu verarbeiten. Die Rechnereinheit ist dabei mit einem entsprechenden Programm derart ausgebildet, dass zu dem hinterlegten Lageplan des Grundstücks, wobei auch eine entsprechende Topografie erfasst sein kann, die einzelnen Sondierungsbohrungen positionsgenau zugeordnet werden. Durch die Programmlogik der Rechnereinheit wird insbesondere ein im wesentlichen horizontaler Schichtaufbau des Bodens unterstellt, wobei zu den einzelnen Sondierungsbohrungen mit Angaben zu Schichten in den jeweiligen Tiefen über die gesamte Grundstücksfläche im Boden ein Schichtaufbau interpoliert wird, wobei ein dreidimensionales Bodenmodell erstellt wird. Insgesamt kann so ein digitales dreidimensionales Bodenmodell erhalten werden, welches anschaulich einen realitätsnahen Aufbau des Bodens wiedergibt. Hierdurch ist es grundsätzlich ermöglicht, schnellere und genauere Abschätzungen zum Erstellen einer Baugrube in dem Boden vorzunehmen. Insbesondere können nahezu beliebige Berechnungen zu eventuell notwendigen Bodenbearbeitungen in einfacher und zuverlässiger Weise durchgeführt werden.

Eine bevorzugte Weiterbildung des erfindungsgemäßen Verfahrens besteht darin, dass die Rechnereinheit mit einer Anzeigeeinrichtung in Verbindung steht und ausgebildet ist, dass zu gewünschten Stellen oder Schnitten zu dem Grundstück ein Schichtaufbau des Bodens gezeigt wird. Dies kann für Planer beim Planen und Bestimmen notwendiger Baumaßnahmen, etwa zum Erstellen einer Bauwerksgründung hilfreich sein.

Eine weitere bevorzugte Ausführungsform der Erfindung besteht darin, dass die Rechnereinheit ausgebildet ist, für einen vorgegebenen Flächenbereich in dem Grundstück Schichtvolumen und/oder Schichtmassen für vorgegebene Aushubtiefen und/oder vorgegebene Schichten anhand des Bodenmodells zu ermitteln und auszugeben. In die Rechnereinheit können über die Tastatur, einen Cursor oder in einer sonstigen Weise ein vorgegebener Flächenbereich für eine Baugrube und eine Aushubtiefe eingegeben werden. Basierend hierauf kann durch die Rechnereinheit für die Baugrube insgesamt aber auch für einzelne Schichten das Aushubvolumen ermittelt und angegeben werden. Dies ermöglicht eine sehr schnelle und sehr genaue Kostenkalkulation beim Erstellen einer Baugrube oder bei sonstigen Bodenabtragsarbeiten, etwa zur Erstellung von Gründungselementen. Aufgrund der Angaben zu den einzelnen Schichten und zum Aufbau der Schichten können dabei auch konkrete Ermittlungen zu den einzelnen Schichtmassen erfolgen, etwa wenn Schichten aus Lehm, Sand, Kies etc. vorgesehen sind.

Gemäß einer weiteren bevorzugten Variante des erfindungsgemäßen Verfahrens ist vorgesehen, dass bei der Erfassung des Lageplans neben einer Fläche auch die Topographie, insbesondere ein Verlauf einer Oberflächenkante, miterfasst wird. Insbesondere bei Baugrundstücken in einem steil abfallenden Gelände können so einzelne Lagen in voneinander beabstandeten Sondierungsbohrungen in einen realitätsnahen Bezug zueinander gesetzt werden. Dies unterstützt eine realitätsnahe Kalkulation bei der Erstellung der Baugrube.

Grundsätzlich ist es vorteilhaft, dass erfasste Daten zu dem Lageplan des Grundstücks und/oder zu den Sondierungsbohrungen mit den Informationen zum Schichtaufbau als digitale Daten der Rechnereinheit zum Erstellen des Bodenmodells zugeführt werden. Die Daten können so insbesondere per Datenfernabfrage aus Datenbanken oder von entsprechenden Datenerfassungseinrichtungen abgefragt und der Rechnereinheit zugeführt werden.

Alternativ oder optional ist es nach einer verteilhaften Variante der Erfindung vorgesehen, dass Daten zu dem Lageplan des Grundstücks und/oder zu den Sondierungsbohrungen mit den Informationen zum Schichtaufbau aus einem analogen Dokument, insbesondere einem Baugrundgutachten, ausgelesen werden. Insbesondere bei größeren Bauvorhaben liegt ein Baugrundgutachten vor, da dieses üblicherweise bei einer zuständigen Baubehörde von einem Gutachter einzureichen ist. In der Regel sind zur Erstellung eines dreidimensionalen Bodenmodells alle Daten in einem derartigen Baugrundgutachten enthalten, wobei dieses in der Regel jedoch eine Vielzahl weiterer Daten und Informationen umfasst, die für die Bestimmung des dreidimensionalen Bodenmodells nicht notwendig sind.

Vorzugsweise ist die Rechnereinheit mit einer Software versehen, welche die Daten zu dem Baugrundstück und den Sondierungsbohrungen automatisch erfasst und zum Bilden des dreidimensionalen Bodenmodells verarbeitet.

Besonders vorteilhaft ist es nach einer Weiterbildung der Erfindung, dass das Auslesen aus einem analogen Dokument mittels eines Scanners und/oder eines Datenerfassungs- und/oder Digitalisierungsprogramms erfolgt. Häufig liegt ein Baugrundgutachten nicht oder nicht vollständig in einer digitalen Form vor, jedoch als ein herkömmliches Dokument, etwa in Papierform, als ein pdf-Dokument oder als ein sonstiges Bilddokument.

Über einen Scanner kann ein analoges Dokument eingelesen werden. Gegebenenfalls unter Verwendung eines Datenerfassungs- und/oder Digitalisierungsprogramms kann das Dokument in eine maschinenlesbare Fassung überführt werden. Insbesondere bei Zeichnungen zu einem Grundstücksplan sowie zum Aufbau der Sondierungsbohrungen werden Zahlen und standardisierte Symbole zur Bodenart verwendet, so dass Maßangaben zum Grundstück und den Bohrungen mit den Schichtdicken sowie zur Art des Schichtmaterials in einfacher Weise erfasst und in eine maschinenlesbare digitale Fassung überführt werden können. Diese Daten können dann ohne Weiteres von der Rechnereinheit erkannt und zur Erstellung des Bodenmodells verwendet und verarbeitet werden.

Grundsätzlich können jedwede Daten zum Aufbau des Bodens bei der Erstellung des Bodenmodells berücksichtigt werden. Besonders vorteilhaft ist es nach einer Weiterbildung der Erfindung, dass die Sondierungsbohrungen als Aufschlussbohrungen und/oder Rahmensondierungen durchgeführt werden. Hierbei können konkret über die Tiefe Daten zu Schichtdicken und dem Aufbau der jeweiligen Schichten zuverlässig erfasst werden.

Eine weitere besonders zweckmäßige Ausgestaltung der Erfindung besteht darin, dass in der Rechnereinheit zu einzelnen Arten von Schichten Kosten je m³, etwa für einen Aushub und /oder eine Entsorgung, hinterlegt werden und dass zu einem vorgegebenen Aushubvolumen durch die Rechnereinheit ein zu erwartender Kostenaufwand bestimmt wird.

Dies ist insbesondere bei einer Bauplanung und/oder für eine Angebotserstellung für Tiefbaumaßnahmen ein erheblicher Vorteil. Dabei kann berücksichtigt sein, dass für bestimmte Bodenarten in einer Schicht höhere oder geringere Kosten je m³ für einen Aushub und/oder eine Entsorgung vorzusehen sind.

Weiterhin ist es nach einer Weiterbildung des erfindungsgemäßen Verfahrens vorteilhaft, dass in der Rechnereinheit zu einzelnen Arten von Schichten geeignete Abtragsgeräte und/oder ein notwendiger Zeitaufwand zum Abtragen/Ausheben je m³ hinterlegt werden und dass zu dem vorgegebenen Aushubvolumen durch die Rechnereinheit ein zu erwartender Zeitaufwand bestimmt wird. Beispielsweise kann eine Bodenschicht mit Felsmaterial nur mit bestimmten Bodenbearbeitungsgeräten, etwa einer Fräse, bearbeitet werden, während lockere Bodenarten, wie etwa Sand oder Kies, mit einfachen und damit günstigeren Aushubgeräten bearbeitet werden können, wie etwa Greifern oder Bohrgeräten. Dies hat eine Auswirkung auf die notwendige Bearbeitungszeit zum Aushub eines entsprechenden m³ sowie zu den dafür anfallenden Kosten, da unterschiedliche Geräte unterschiedliche Gerätestundensätze haben. Derartige Gerätestundensätze und Bearbeitungszeiten je m3 für eine bestimmte Bodenart können in der Rechnereinheit in einem entsprechenden Speicher hinterlegt sein.

Neben derartigen Daten für eine Arbeitsablauf- und Kostenplanung ist es nach einer weiteren Ausführungsvariante der Erfindung vorteilhaft, dass anhand des Bodenmodells eine Tragfähigkeit von vorgegebenen Gründungselementen, etwa Gründungspfählen oder bei einer vorgegebenen Tragfähigkeit eine Dimensionierung von Gründungselementen ermittelt wird. So kann durch die Rechnereinheit bei dem hinterlegten Bodenmodell auch eine Aussage darüber getroffen werden, welche Arten von Gründungselementen, welche Größe und/oder mit welcher Tiefe Gründungselemente auszubilden sind. Hierzu können auch entsprechende Informationen zu Bearbeitungszeiten, Bearbeitungskosten sowie notwendigen Geräten unmittelbar durch die Rechnereinheit bestimmt werden.

Insbesondere ist es nach einer Weiterbildung der Erfindung vorteilhaft, dass in der Rechnereinheit Daten zu Kosten zu Gründungselementen hinterlegt werden und eine automatische Kostenbestimmung zu erstellenden Gründungselementen anhand des Bodenmodells durchgeführt wird. Auch dies ist bei einer Angebotserstellung für Tiefbaumaßnahmen an einem Grundstück ein erheblicher Vorteil.

Die Erfindung wird nachfolgend anhand von bevorzugten Ausführungsbeispielen weiter erläutert, die schematisch in den Zeichnungen dargestellt sind. In den Zeichnungen zeigen:
- Fig. 1: eine Draufsicht auf einen Lageplan eines Grundstücks;
- Fig. 2: eine schematische Querschnittsansicht zu einem Schichtaufbau bei drei beabstandeten Sondierungsbohrungen mit interpoliertem Schichtverlauf; und
- Fig. 3: eine beispielhafte graphische Darstellung zu einem dreidimensionalen Bodenmodell.

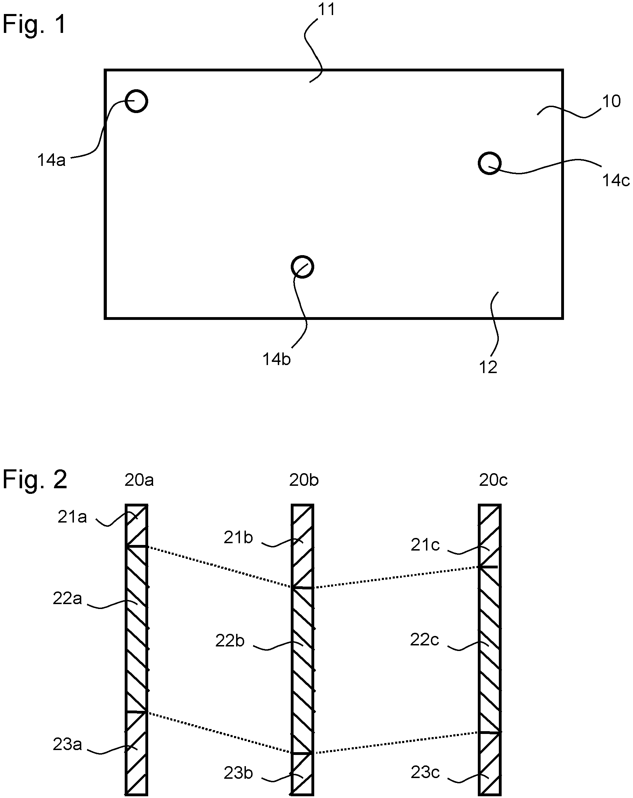

Figur 1 zeigt schematisch einen Lageplan 11 zu einem Grundstück 10, insbesondere einem Baugrundstück. Das Grundstück 10 kann mit einer Topografie 12 versehen sein, welche nicht eben ist. Beispielhaft sind in dem Lageplan 11 drei Sondierungsstellen 14a, 14b, 14c angezeigt, welche voneinander beabstandet sind und an welchen Sondierungsbohrungen durchgeführt werden.

Figur 2 zeigt jeweils einen möglichen Schichtaufbau 20 an einer jeweiligen Sondierungsstelle 14, wobei der Schichtaufbau 20a sich auf die erste Sondierungsstelle 14a, der Schichtaufbau 20b auf die zweite Sondierungsstelle 14b und der dritte Schichtaufbau 20c auf die dritte Sondierungsstelle 14c bezieht.

Dem jeweiligen Schichtaufbau 20 ist zu entnehmen, dass bis zu einer vorgegebenen Tiefe der Boden jeweils aus einer ersten Schicht 21, einer zweiten Schicht 22 und einer dritten Schicht 23 aufgebaut ist. Die Dicke der Schichten 21, 22, 23 in Bezug auf die Tiefe weicht dabei an den einzelnen Sondierungsstellen 14 voneinander ab, wie anschaulich in Figur 2 dargestellt ist. Die Schichten 21, 22, 23 and den einzelnen Sondierungsstellen 14a, 14b, 14c sind jeweils mit den Bezeichnungen a, b und c versehen.

Basierend auf diesen ermittelten Daten zu dem Schichtaufbau 20 an den einzelnen Sondierungsstellen 14 kann zu dem Lageplan 11 ein Schichtverlauf über die gesamte Fläche des Grundstücks 10 durch eine Rechnereinheit ermittelt werden. Die Rechnereinheit ist dabei mit einem Programm versehen, welches anhand der Sondierungsbohrungen mit dem jeweils festgestellten Schichtaufbau 20a, 20b, 20c den Verlauf der Schichten und Schichtgrenzen über die Grundstücksfläche interpoliert, wobei vorzugsweise die Schichtgrenzen an den Sondierungsstellen 14 als Stützpunkte dienen und bei der Berechnung ein weitgehend harmonischer und/oder horizontaler Schichtverlauf unterstellt wird. Es versteht sich, dass mit steigender Anzahl von Sondierungsstellen 14 mit entsprechenden Sondierungsbohrungen der durch die Rechnereinheit rechnerisch interpolierte Schichtaufbau realitätsnäher wird.

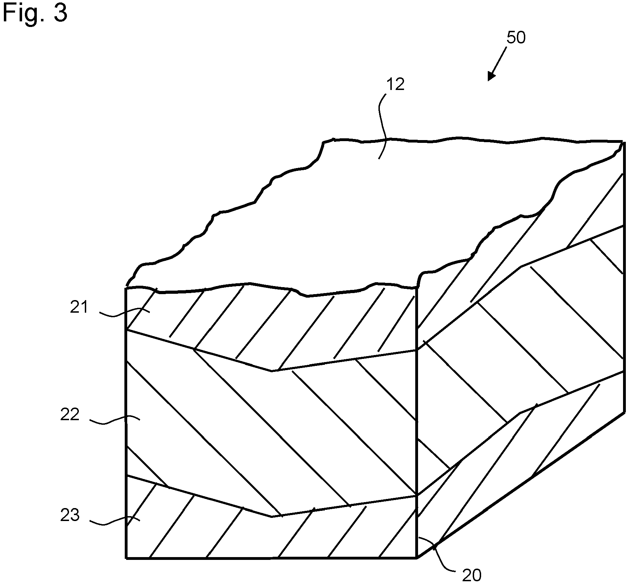

Durch die Rechnereinheit wird anhand der so ermittelten und eingegebenen Daten ein dreidimensionales Bodenmodell 50 als ein Daten- oder Rechnermodell bestimmt und errechnet. Eine mögliche graphische Darstellung eines dreidimensionalen Bodenmodels 50 ist anschaulich in Figur 3 dargestellt. Das Bodenmodell 50 zeigt das Grundstück 10 mit einer unebenen Topographie 12 an der Oberfläche. Weiterhin wird ein errechneter Schichtdickenverlauf der ersten Schicht 21, der zweiten Schicht 22 und der dritten Schicht 23 entsprechend der durchgeführten Sondierungsbohrungen ermittelt und angezeigt.

Daten zu den Abmessungen des Grundstücks, den Sondierungsbohrungen und/oder zu einer zu erstellenden Baugrube können vorzugsweise als oder basierend auf GPS-Daten in die Rechnereinheit eingegeben werden.

Basierend auf den Daten zu einen derart bestimmten dreidimensionalen Bodenmodell 50 können bei Eingabe von entsprechenden Dimensionen zu einer zu erstellenden Baugrube oder zu sonstigen Baumaßnahmen im Boden realitätsnahe Abschätzungen zu Aushubvolumen bei einzelnen Schichten sowie weitere Aussagen getroffen werden.

## Patentansprüche

1. Verfahren zum Erstellen eines dreidimensionalen Bodenmodells (50) zu einem Grundstück (10), insbesondere einem Baugrundstück, wobei
- Daten zu einem Lageplan (11) des Grundstücks (10) erfasst werden,
- Daten zu mehreren Sondierungsbohrungen erfasst werden, welche auf dem Grundstück an bestimmten Sondierungsstellen (14) durchgeführt wurden und zu jeder Sondierungsbohrung ein Schichtaufbau (20) des Bodens mit einzelnen Schichten (21, 22, 23) und ihrer Schichtdicke ermittelt wurden,
- die einzelnen Sondierungsstellen (14) in dem erfassten Lageplan (11) des Grundstücks (10) eingetragen werden,
- wobei mittels einer Rechnereinheit die einzelnen Schichten (21, 22, 23) zu jeder Sondierungsbohrung analysiert und jeweils einer gemeinsamen Bodenschicht zugeordnet werden,
- abhängig von der Lage der einzelnen Sondierungsbohrungen zueinander ein Schichtdickenverlauf der einzelnen Bodenschichten innerhalb des Grundstücks (10) interpoliert wird und
- so durch Rechnereinheit das dreidimensionale Bodenmodell (50) für das Grundstück erstellt wird.

2. Verfahren nach Anspruch 1,
**dadurch gekennzeichnet,**
**dass** die Rechnereinheit mit einer Anzeigeeinrichtung in Verbindung steht und ausgebildet ist, dass zu gewünschten Stellen oder Schnitten zu dem Grundstück (10) ein Schichtaufbau (20) des Bodens angezeigt wird.

3. Verfahren nach Anspruch 1 oder 2,
**dadurch gekennzeichnet,**
**dass** die Rechnereinheit ausgebildet ist, für einen vorgebbaren Flächenbereich in dem Grundstück (10) Schichtvolumen und/oder Schichtmassen für vorgegebene Aushubtiefen und/oder vorgegebene Schichten (21, 22, 23) anhand des Bodenmodells (50) zu ermitteln und auszugeben.

4. Verfahren nach einem der Ansprüche 1 bis 3,
**dadurch gekennzeichnet,**
**dass** bei der Erfassung des Lageplans (11) neben einer Fläche auch die Topografie, insbesondere ein Verlauf einer Geländeoberkante, miterfasst wird.

5. Verfahren nach einem der Ansprüche 1 bis 4,
**dadurch gekennzeichnet,**
**dass** erfasste Daten zu dem Lageplan (11) des Grundstücks (10) und/oder zu den Sondierungsbohrungen (14) mit den Informationen zum Schichtaufbau (20) als digitale Daten der Rechnereinheit zum Erstellen des Bodenmodells (50) zugeführt werden.

6. Verfahren nach einem der Ansprüche 1 bis 4,
**dadurch gekennzeichnet,**
**dass** Daten zu dem Lageplan (11) des Grundstücks (10) und/oder zu den Sondierungsbohrungen mit den Informationen zum Schichtaufbau (20) aus einem analogen Dokument, insbesondere einem Baugrundgutachten, ausgelesen werden.

7. Verfahren nach Anspruch 6,
**dadurch gekennzeichnet,**
**dass** das Auslesen aus einem analogen Dokument mittels eines Scanners und/oder eines Datenerfassungs- und/oder Digitalisierungsprogramms erfolgt.

8. Verfahren nach einem der Ansprüche 1 bis 7,
**dadurch gekennzeichnet,**
**dass** die Sondierungsbohrungen als Aufschlussbohrungen und/oder Rahmensondierungen durchgeführt werden.

9. Verfahren nach einem der Ansprüche 1 bis 8,
**dadurch gekennzeichnet,**
**dass** in der Rechnereinheit zu einzelnen Arten von Schichten (21, 22, 23) Kosten je Kubikmeter, etwa für einen Aushub und/oder eine Entsorgung, hinterlegt werden und
**dass** zu einem vorgegebenen Aushubvolumen durch die Rechnereinheit ein zu erwartender Kostenaufwand bestimmt wird.

10. Verfahren nach einem der Ansprüche 1 bis 9,
**dadurch gekennzeichnet,**
**dass** in der Rechnereinheit zu einzelnen Arten von Schichten (21, 22, 23) geeignete Abtragsgeräte und/oder ein notwendiger Zeitaufwand zum Abtragen/Ausheben je Kubikmeter hinterlegt werden und
**dass** zu dem vorgegebenen Aushubvolumen durch die Rechnereinheit ein zu erwartender Zeitaufwand bestimmt wird.

11. Verfahren nach einem der Ansprüche 1 bis 10,
**dadurch gekennzeichnet,**
**dass** anhand des Bodenmodells (50) eine Tragfähigkeit von vorgegebenen Gründungselementen, etwa Gründungspfählen, oder bei einer vorgegebenen Tragfähigkeit eine Dimensionierung von notwendigen Gründungselementen ermittelt wird.

12. Verfahren nach einem der Ansprüche 1 bis 11,
**dadurch gekennzeichnet,**
**dass** in der Rechnereinheit Daten zu Kosten zu Gründungselementen hinterlegt werden und eine automatische Kostenbestimmung zu erstellenden Gründungselementen anhand des Bodenmodells (50) durchgeführt wird.
